(19) **Europäisches Patentamt**

**European Patent Office**

**Office européen des brevets**

(11) **EP 1 136 440 A1**

(12) **EUROPEAN PATENT APPLICATION**

(43) Date of publication:
26.09.2001 Bulletin 2001/39

(51) Int Cl.7: **B81B 3/00**, G01J 5/20, H01L 31/09

(21) Application number: 00201083.3

(22) Date of filing: 24.03.2000

(84) Designated Contracting States:
**AT BE CH CY DE DK ES FI FR GB GR IE IT LI LU MC NL PT SE**
Designated Extension States:
**AL LT LV MK RO SI**

(71) Applicant: **INTERUNIVERSITAIR MICRO-ELEKTRONICA CENTRUM VZW**
**3001 Leuven Brabant (BE)**

(72) Inventors:
- **De Moor, Piet**
  **3210 Linden (Lubbeek) (BE)**
- **van Hoof, Chris**
  **3001 Leuven (BE)**

(74) Representative: **Bird, William Edward et al**
**Bird Goen & Co.,**
**Vilvoordsebaan 92**
**3020 Winksele (BE)**

(54) **Method of improving mechanical strenghtin micro electro mechanical systems and devices produced thereof**

(57) Structures, methods and means are presented to produce mechanical strength in Micro Electro Mechanical Systems by increasing the moment of inertia of some of the composing elements. A thermal sensor is obtained with improved mechanical strength, thermal insulation and time constant. The proposed invention is also advantageous in terms of the process time and process cost, especially lithographic patterning.

Figure 8

EP 1 136 440 A1

## Description

### Field of invention

The present invention is related to a method of improving mechanical strength in Micro Electro Mechanical Systems (MEMS). This method is used to produce MEMS devices with improved mechanical characteristics.

### Background of the invention

Micro Electro Mechanical Systems (MEMS), also known as Microsystems or Micro Machined Systems, use the process technology as developed in semiconductor processing to obtain devices with the desired mechanical properties. In MEMS technology these mechanical devices on microscale are embedded in micro-electronic circuitry. MEMS devices serve as an intermediate between the non-electrical and the electrical world or as transducers between physical quantities e.g. transforming radiation or pressure into current. Contrary to semiconductor devices mechanical properties such as weight, vibration, etc. are crucial for MEMS devices. The characteristics of Micro Electro Mechanical Systems (MEMS), e.g. accelerometers, thermal sensors, membrane-devices etc., are thus determined by both their transducing and mechanical properties. The strong interaction between the transducing and mechanical properties of these systems often imposes restrictions on meeting simultaneously both types of specifications.

Examples of Micro Electro Mechanical Systems devices are thermal sensors. Thermal sensors measure a temperature rise resulting from the deposition of an amount of energy within a thermally insulated piece of material, this insulated piece being the sensing element. The energy can result from a variety of interactions between the environment and the sensing element, e.g. X-ray or infrared flux absorption, reacting molecules. A "Method of fabrication of an infrared radiation detector and more particularly an infrared sensitive bolometer" is the subject of a European Patent no 0 867 702. Thermal analysis shows that the change in temperature is proportional to the thermal insulation of the device layer, the energy deposited in this layer being in general a given quantity. The better the thermal insulation of the sensing element, the more sensitive the device becomes. The energy, deposited in the sensing element, will not or to a less degree, leak away to the environment thanks to the better insulation. A larger change in temperature is thus obtained for a given amount of incident energy. Maximum thermal insulation can be obtained by suspending the sensing element on thin narrow and long beams of a thermally insulating material, so that the sensing layer is only connected to the rest of the device by these suspending beams. Between the sensing element and underlying layers there is a gap resulting in a better thermal insulation of the sensing element.

The very last process step, being the removal of the sacrificial layer between the sensing element and the underlying substrate thereby creating the aforementioned gap, is critical and difficult. This removal is generally done by a wet etch. Due to a general problem in surface micromachining, called sticking, the removal of such a sacrificial layer causes a lot of yield loss. During the wet etch of the sacrificial layer, the surface tension of droplets under the sensing element pull this sensing element towards the substrate. Once the sensing element reaches the substrate, strong bonding forces between this sensing element and the substrate along with the mechanical weakness of the supporting beams prevent the sensing element from returning to its original position. Once the sensing element touches the substrate the device has a large thermal conductance to the substrate and is useless as bolometer. Making the supporting beams thinner will improve the thermal insulation of the sensing element but turns out to make the problem of sticking more severe, resulting in yield loss during processing and packaging of such devices.

In "Mechanical performance of an integrated microgimbal/microactuator for disk drives", Proc. of the Transducers '99 Conference, June 1999, Sendai, Japan, p. 1002-1005 (1999) by L. Muller, J.M. Noworolsky, R.T. Howe and A.P. Pisano a specific structure is presented to improve the mechanical strength of parts of an assembled device, i.e. an device for reading data stored in a disk drive. However this structure is obtained at the expense of additional, time consuming, process steps. These process steps cannot be done in the course of producing the gimbal, but require separate processing, followed by assembly. The proposed process uses thick layers having large dimensions up to 75 micrometer in this so-called high-aspect-ratio fabrication technology. Only the torsional stiffness is improved, no other mechanical or physical characteristics of the device are involved by the processing of the microgimbal.

### Aim of the invention

The present invention aims in improving the mechanical stability of the MEMS devices. The improved mechanical strength can lead to higher production and packaging yield. It can also improve the operation of MEMS devices that have moving elements. By introducing this method, the thickness of layers can be adapted to meet other technological specifications and still have sufficient mechanical strength. The improved mechanical strength can lead to higher production and packaging yield. The improvement in mechanical strength with respect to the device properties can be expressed in terms of a figure of merit M. In the finished MEMS device, layers may indeed not be fully supported by an underlying layer and hence lack mechanical strength.

Another aim of the present invention is to obtain a device for sensing electromagnetic radiation with improved mechanical characteristics and device performance.

Another aim of the present invention is to obtain an infrared sensor with improved mechanical characteristics and device performance. An advantage of this device is that the thickness of the layer, e.g. the sensing layer, can be adapted to have the maximum temperature sensitivity thanks to a minimal thermal conductance possible for a given layout or material choice. Another advantage of such a device is that the time constant of this thermal sensor is minimized to such a level that the device can be applied in fast thermal sensor camera applications. The improved mechanical strength allows using a minimal layout of the devices so the thermal sensor can be used in an array-type of circuitry. The improvement in mechanical strength with respect to the device properties can be expressed in terms of a figure of merit M.

**Summary of the invention**

In the following application the term "layer" should be understood as a stack of at least 1 layer. With U or I-shaped layer is meant that a part of the cross section of this layer has an I or U-shaped profile. The dimensions are given in micrometer, using the symbols micron or m, or in square micrometer, using the symbol m$^2$.

In one aspect of the invention MEMS devices with improved mechanical characteristics are provided.

In one embodiment of the invention the resistance of layers in MEMS devices to bending, lateral or torsion forces, having a static or dynamic nature, is increased by having these layers preferably in an I or U-profile instead of using the conventional rectangular profiles. In the finished MEMS device, layers may indeed not be fully supported by an underlying layer and hence lack mechanical strength.

In another embodiment of the invention a method is presented to obtain the I or U-shaped layers by applying a sequence comprising processing steps, such as depositing and patterning of layers, as is a common practice in MEMS process technology in specific and more generally in semiconductor process technology.

In another aspect of the invention a device is presented containing at least one I or U-shaped layer.

In another embodiment of the invention these I and U-profiles can be repeated along the layer. The profiles may be combined within the layer.

In another aspect of the invention a thermal sensor is presented having improved mechanical strength to bending or lateral forces, by applying a U-shaped layer or a combination thereof.

**Description of the drawings**

Figure 1: typical layout and dimensions of an uncooled bolometer with rectangular supporting beams a: top view, b: cross section, 11 = sensing element or pixel, 12 = supporting beam

Figure 2: example of the side view of a bolometer, a device to transform radiation into electric parameters. 21 = sensing element, 22 = sacrificial layer, 23 = substrate

Figure 3: example of an infrared bolometer where the sensing element (31), in the middle of the picture, is suspended by two narrows beams with rectangular cross section (32). There is a gap between the sensing element (31) and the substrate (33)

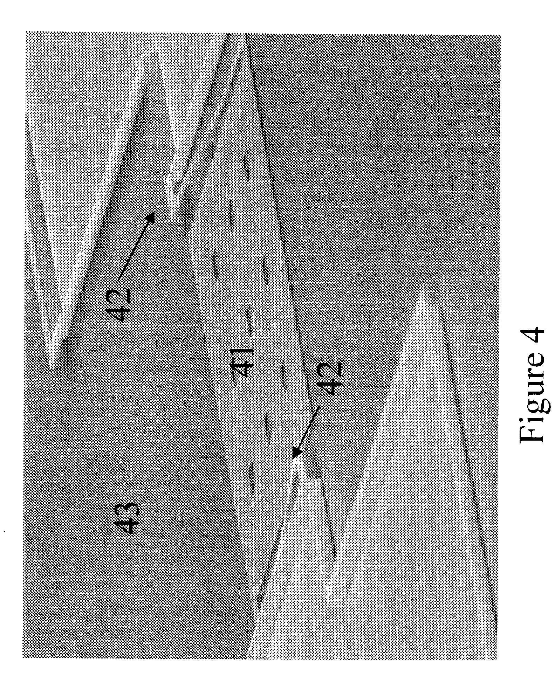

Figure 4: example of an infrared bolometer illustrating the case where the supporting beams (42) bend towards the substrate (43) due to the sticking phenomenon.

Figure 5: schematic representation of a cantilever (51) having length L, being a freestanding element, only attached at one side to the substrate (53).

a: side view, bending force F resulting in a bending D and lateral force K being applied perpendicular to the plane of the paper,

b: top view, lateral force K resulting in a bending D$_1$ and bending force F being applied perpendicular to the plane of the paper

Figure 6: cross sections of different beam layouts and their corresponding moment of inertia I and cross sectional area S:

a: rectangular beam
b: I-profile,
c: U-profile

Figure 7: processing of an infrared sensor, according to one embodiment of European Patent no 0 867 702

Figure 8: example of the processing of an infrared sensor with U-shaped supporting beams, according to one embodiment of the invention

Figure 9: example of the processing of an infrared sensor with I-shaped supporting beams, according to one embodiment of the invention

Figure 10: figure of merit M, comparing the ratio of the moment of inertia I and the beam cross section S for rectangular and U-shaped supporting beams. The figure of merit M is plotted as function of beam width $B_u$, device layer thickness t and depth d of the cavity. The value of width $B_u$ and depth d is kept constant, while the thickness t of the layer is varied, and hence the value of dimensions $H_u$, $h_u$ and $b_u$. All the dimensions of both profiles can be adapted by changes in processing parameters. Dimensions are given in micrometer (micron, μm).

Figure 11: example of a bolometer comparison of cross section S, deflection D due to bending, deflection $D_1$ due to lateral force, time constant $\tau$

      a: supporting beam having rectangular cross section
      b: supporting beam having U-profile cross section

Figure 12: Scanning electron microscope (SEM) topview pictures illustrating the influence of profiling the supporting beams (123) and/or the pixel or planar element (122) on the deformation of the sensor due to the internal stress of the material. Thickness of the polySiGe layer was less then 100nm. The area of the pixel is 50 by 50 square microns. (substrate = 121)

      a) no profiling of the beams and the pixel, the planar element is bending upwards
      b) beams having U-shaped cross section, planar element has no profile
      c) beams having U-shaped cross section, planar element has U-shaped topography

Figure 13: (a) example of a cross section of a MEMS layer having a U-profile applied in x and y-direction.
(b) SEM topview picture showing an example of how the integrated profiling as presented in the invention can create any desired topography in the planar element (132). Here the IMEC-logo is defined. The planar element is 100 by 100 $m^2$. The thickness of the layer is less then 250 m.

Figure 14: illustration of the improved strength of the sensor due to the profiling of the layer: pixel (142), substrate (141), beams (143). A piece of silicon is put on top of the pixel. No deformation of the pixel or beams is noticed.

Figure 15: SEM picture showing

      (a) the start of an U-shaped supporting beam (152) and its connection to the substrate (153)
      (b) the connection between the supporting beam (152) and the planar element (151)

## Detailed description

Fur the purpose of teaching of the invention, preferred embodiments of the method are described in the sequel. The present invention will be described with respect to certain embodiments and drawings. It will however be apparent to the person skilled in the art that other alternatives and equivalents or embodiments of the invention or combinations thereof can be conceived and reduced to practice without departing from the true spirit of the invention as defined in the attached claims.

The mechanical stability of the MEMS devices needs to be improved because this improvement can result in larger production and packaging yield, as the device can withstand mechanical shocks and loads better e.g. during handling. Mechanical stability can also lead to a better operation of the device, as the device has a higher resistance to external mechanical or chemical forces, which can be present during fabrication or operating of the device. One approach might be to attempt to improve the mechanical stability of the MEMS devices only by increasing the dimensions of the layers, e.g. by using thicker layers. Thicker layers can however decrease the sensitivity and efficiency of the MEMS-devices. Thicker layers can lead to increased process cost and process time. Methods and structures need to be developed to improve the mechanical stability of the devices without having to increase the dimensions of the processed layers. Moreover the dimensions of the processed layers should ideally be decreased.

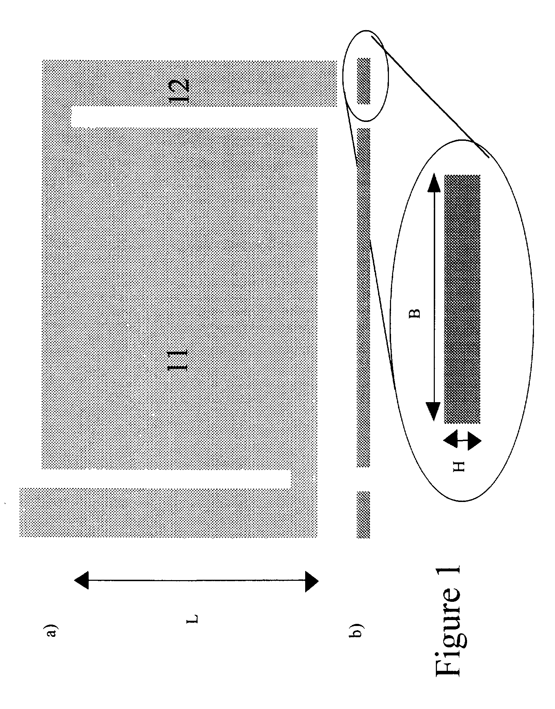

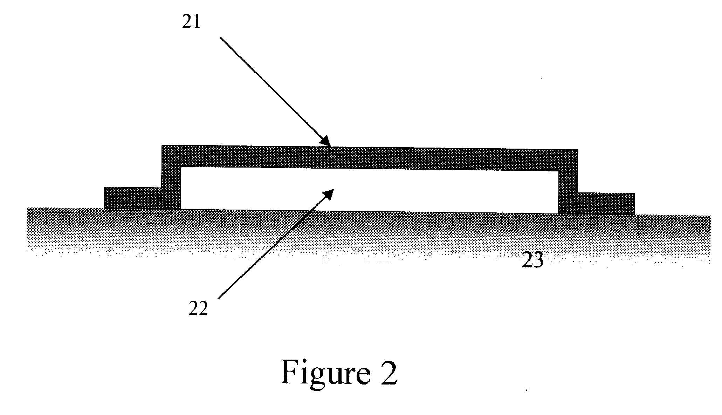

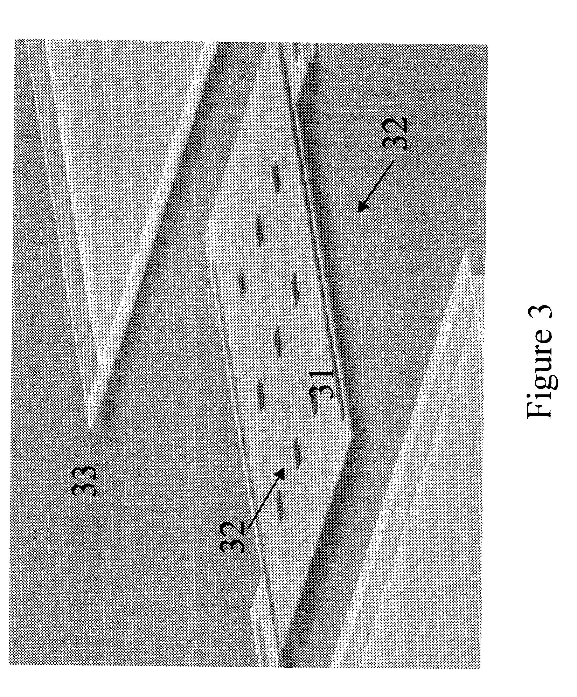

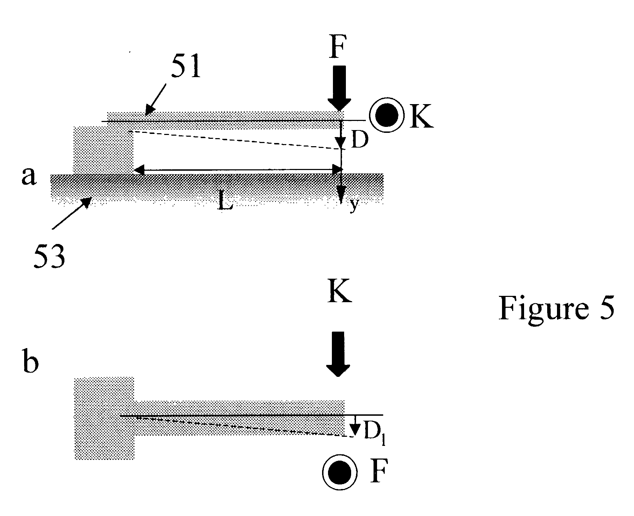

For the purpose of this invention, the mechanical properties of Micro Electro Mechanical Systems (MEMS), more specific bolometers or infrared sensors, are described using the mechanical bending behavior of cantilevers. A bolometer is a device to transform radiation into electric parameter. A cantilever is an elongate beam only supported at one of its four sides, that is at one of its ends. Such a cantilever, as shown in figure 5, is a rather good model for the mechanical behavior of the bolometer beams, supporting the sensing element, as shown in figure 3. These beams are the most fragile part of the bolometer. Finite element simulations allow study of complex systems such as a complete bolometer. Only qualitative results can be obtained from the cantilever analysis however. A schematic representation of such a bolometer is given in figure 1, showing the sensing element (11) suspended by 2 rectangular beams (12) having dimensions length L, width B and height H. A schematic side view of the sensing element (21), still supported by a sacrificial layer (22), on top of substrate (23) is given in figure 2. This substrate can be a semiconductor substrate.

When applying a force F at the end of a cantilever with length L, the cantilever deflection D at the end of the cantilever is direct proportional to F, the third power of L and inversely proportional to the Young modulus of the cantilever material E, and its moment of inertia I:

$$D \approx \frac{FL^3}{IE} \qquad (2)$$

For a given force F, e.g. the weight of the pixel structure, surface tension during the etching of the sacrificial layer, the deflection D can be minimized by reducing the length L, or by increasing the moment of inertia I and the Young modulus E. However, the Young modulus E is a given material property, and the variations from one material to another are generally small, as compared to the decrease in deflection obtained when changing length L or moment of inertia I.

Indeed, a reduction of the cantilever length L with a factor of 2 already results in a deflection being 8 times smaller. Since the thermal insulation of a bolometer is however proportional to the length of the beams, this is not an effective route to enhance the beam stiffness while maintaining a high thermal insulation. So, the most important parameter to change is the moment of inertia I, which is defined in classical mechanics as follows:

$$I = \int_S y^2 dS \qquad (3)$$

S is the cross section of the cantilever. The y-axis is defined by the direction in which the force is applied, and hence the deflection. The origin of this y-axis is defined by the so-called neutral axis of the cantilever, which is in fact the center of mass defined by:

$$\int_S y dS = 0 \qquad (4)$$

Qualitatively these formulas express that the stiffness of a cantilever, as given by the moment of inertia, increases quadratically with the amount of material that is far away, having a large y-value, from the center of mass in the direction of the applied force. In case of the classical rectangular beam shape, having width B and a height H, the moment of inertia $I_r$ is:

$$I_r = \frac{BH^3}{12} \qquad (5)$$

From formula (5) it is clear that a gain in thermal insulation obtained through a reduction of the beam height H being equal in this case to the layer thickness t, results in a smaller moment of inertia, and thus in a larger deflection d for a given force F.

From the above it can be concluded that if only the dimensions of the rectangular profile are changed to increase the moment of inertia, mechanical and device specifications are in conflict. For example, in case of bolometers, the moment of inertia I must increase while maintaining a good thermal insulation. Not only the dimensions have to change, also the cross section and the layout of the profile have to change in order to obtain a MEMS device with improved mechanical strength that can also be independent of the sensing properties of the device. However one has to keep in mind that MEMS processing is considered as a two-dimensional kind of processing. After depositing the layers, these layers are patterned but the thickness of these layers remains constant, changes due to process variations or dependencies not being taken into account. The cross section or profile of the layers is not deliberately changed. If the change of profiles of the supporting beams or other elements can be done as an integral part of the processing of the MEMS device, the steps of assembling the MEMS device and the supporting structure can be omitted, avoiding additional yield problems.

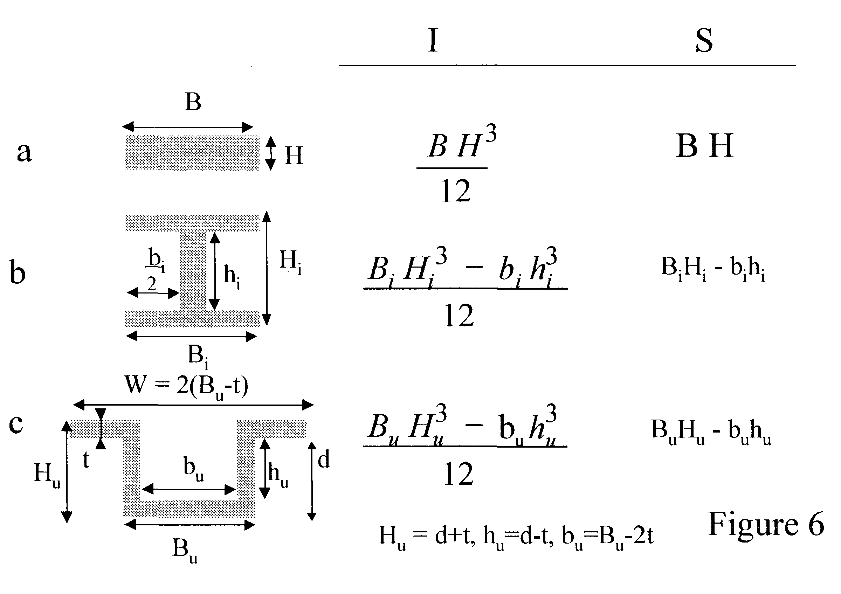

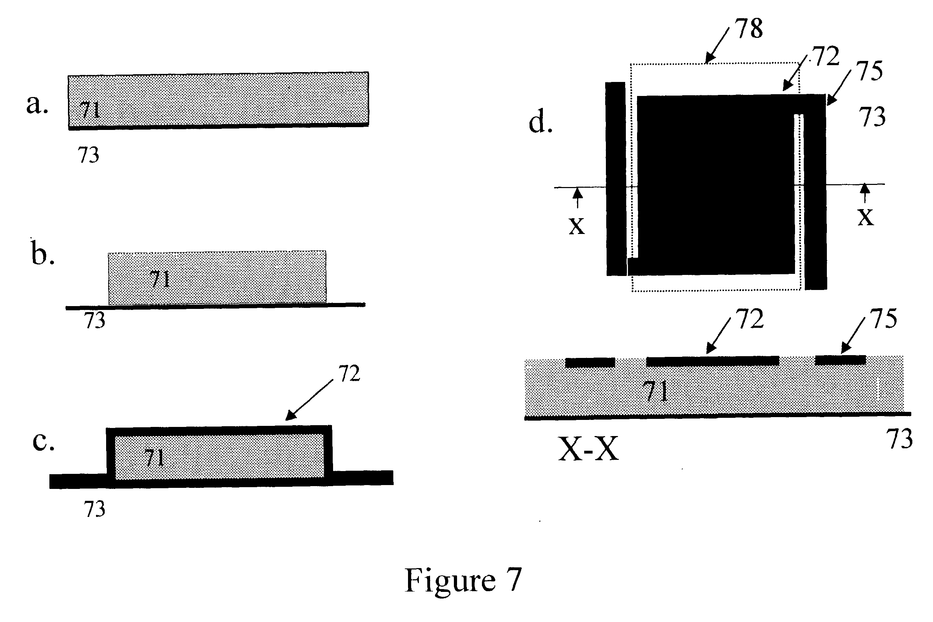

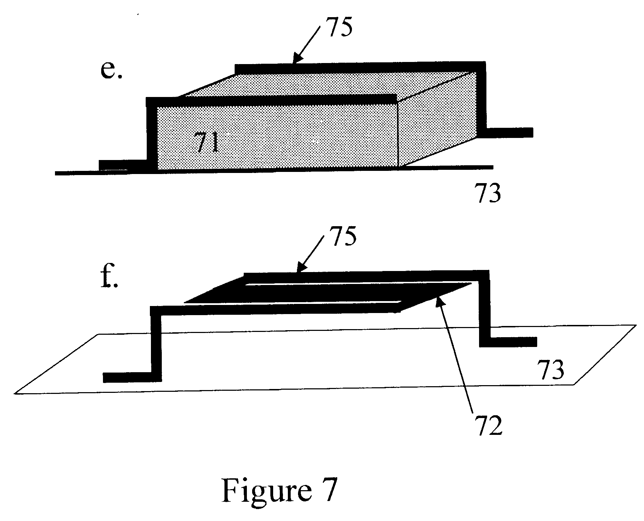

Figure 6 lists different possible cross sections of the supporting beams and their corresponding moment of inertia I and cross sectional area S. The symbols in figure 6 have the following meaning:

a. B, H: respectively width and height of the beam with rectangular cross section

b. $B_i$, $H_i$: respectively outer width and outer height of the I-shaped beam $b_i$, $h_i$: inner dimensions of the I-shaped beam

c. $B_u$, d: width and depth of the cavity, created during partial etching of the sacrificial layer

t = thickness of the device layer

W = 2 ($B_u$-t) : beam width of the U-shaped beam

$h_u$ = d-t: inner height

$b_u$ = $B_u$ - 2t: inner width

$H_u$ = d + t = outer height

From figure 6 it can be concluded that a U-profile can offer the same maximal mechanical strength and minimum cross section as an I-profile in comparison to the rectangular profile. In general U-profiles with different dimensions are possible, however the U-profile given in figure 6 combines an optimal mechanical strength and a minimized cross section. Minimum cross section implies minimum weight and a low thermal conductivity in case of thermally insulated MEMS devices, such as bolometers.

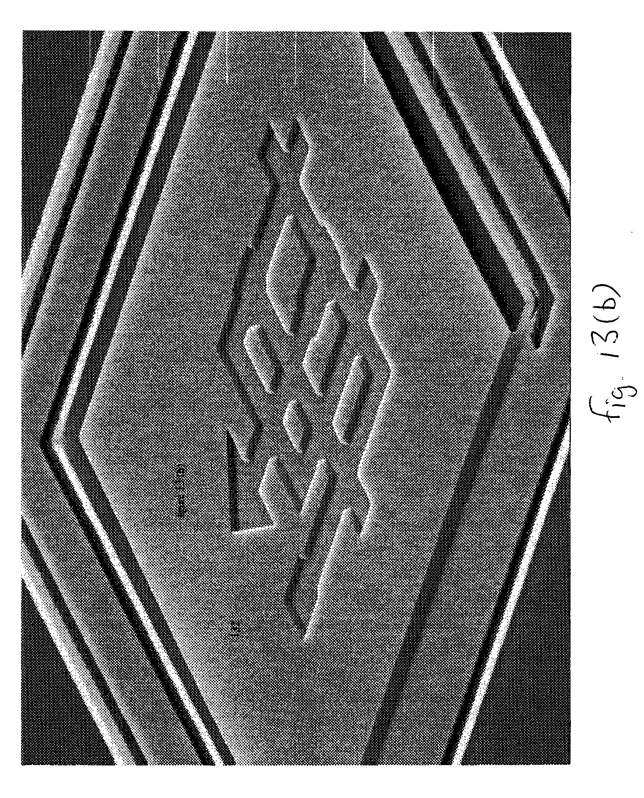

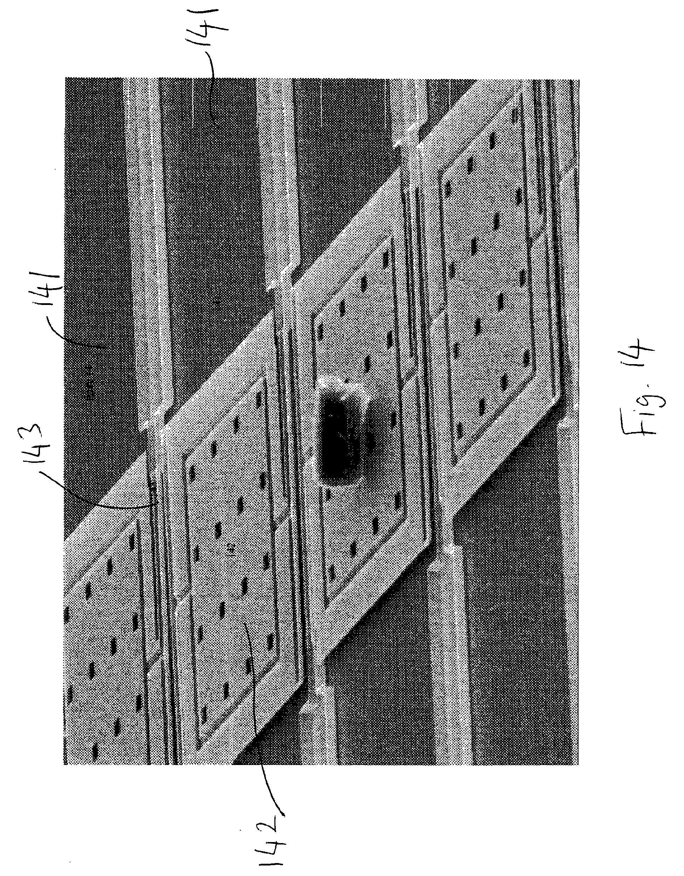

Improved mechanical strength can also allow the use of thicker device layers. For example in X-ray bolometers a thick absorber layer needs to be used in order to capture the X-rays. With the improved mechanical strength of the supporting beams using a thick absorber layer on top of the sensing element is feasible. This improvement in mechanical strength is illustrated in figure 14.

If the sensor is to be arranged in array-type circuitry, e.g. as pixels in a camera application, minimal layout (footprint) of the sensor is important to increase the pixel density. Minimal layout can be obtained by minimal length of the supporting beams, but decreasing the length L of these beams will increase the thermal conductivity G as explained in formula 1. However, by using e.g. U-shaped beams, a thin beam with low thermal conductivity G, see formula 1, but high enough mechanical strength is obtained. The small cross section of the beam compensates for the small length of the beam, thereby resulting in a low enough thermal conductivity G.

Larger devices can be made because for a given layer thickness the dimensions of the sensing element can be increased as the mechanical strength of the supporting elements is increased. For example in a bolometer the pixel can be extended till above the reading circuitry, thereby improving the fill factor of the sensor. Functionality of the devices can increase, as for example multiple layers can be stacked on top of each other.

For the purpose of understanding the present invention a bolometer using U-shaped supporting beams will be described in more detail. Having the same excellent stiffness and minimum cross section of an I-profile, the U-profile is easier to manufacture. The "Method of fabrication of an infrared radiation detector and more particularly an infrared sensitive bolometer" is the subject of a European Patent no 0 867 702. This application is incorporated by reference.

The processing of a bolometer according to an embodiment of this patent is illustrated in figure 7, comprising the following steps:

a) forming a sacrificial layer (71) on a substrate (73)

b) patterning of the sacrificial layer (71). The sacrificial layer remains where the sensing element and the supporting beams will be defined.

c) deposition of semiconductor layer such as polycrystalline Silicon Germanium (SiGe) (72), on this patterned sacrificial layer

d) patterning of device layer (72), defining the geometrical dimensions of the sensing element (78) and of the supporting beams (75). A top view and a cross section XX are shown. The sensing element is entirely located within the boundaries of the sacrificial layer, as patterned during step b.

e) The supporting beams (75) are partially located on this sacrificial layer (71), as one end contacts the substrate (73). The sensing element is not drawn in this figure.

f) Etching of the sacrificial layer, thereby releasing the sensing element and the supporting beams. The sensing element (72) is contacted with the supporting beams (75), the supporting beams are contacted with the substrate (73). Only the beams (75) mechanically support the sensing or planar element (72).

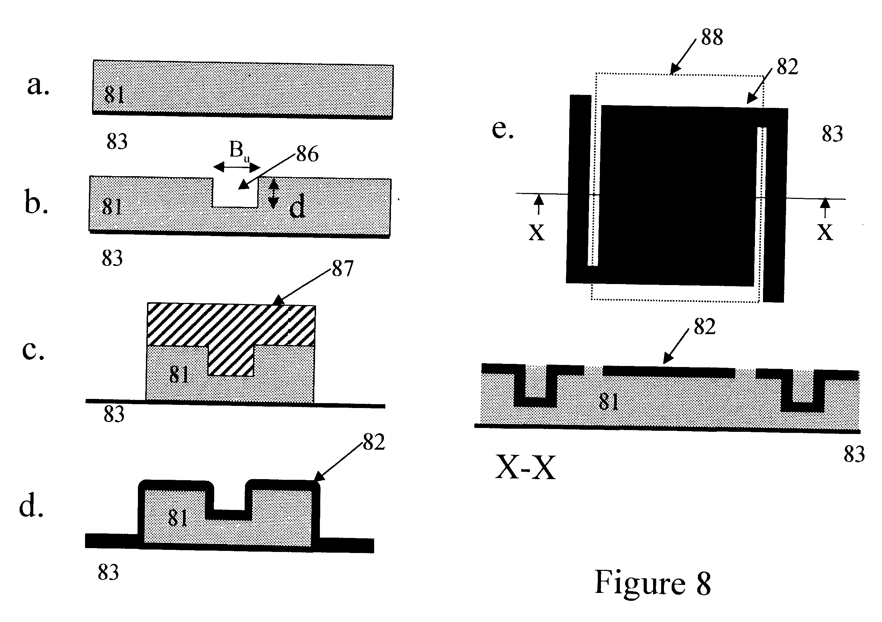

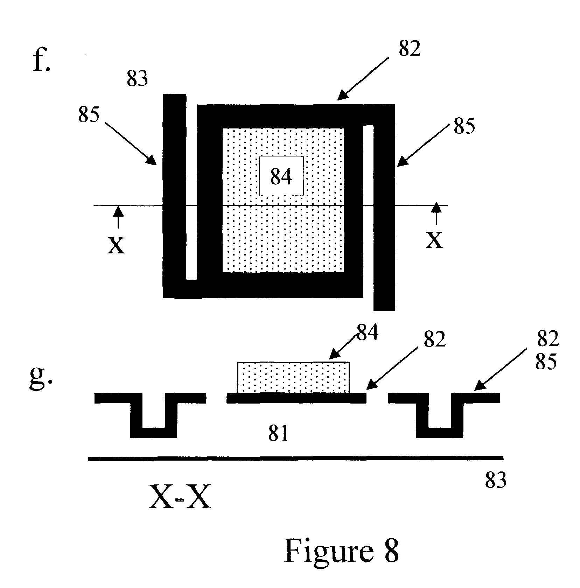

The processing of a bolometer having U-shaped supporting beams comprises the following steps, as illustrated in figure 8:

a) forming a sacrificial layer (81) on a substrate (83)

b) patterning only a part of this sacrificial layer. The obtained opening, cavity or trench (86) has a width $B_u$. The sacrificial layer is locally etched till a depth d. Patterning can be done with several techniques e.g. lift-off or lithographic pattern definition, dry or wet etching and the removal of the photoresist layer

c) patterning of the sacrificial layer, thereby protecting by means of a protective layer (87), e.g. by means of a photoresist layer the opening etched in step b,

d) depositing a semiconducting layer, e.g. polycrystalline Silicon Germanium (SiGe) (82), on this patterned sacrificial layer, thereby defining the profile and cross section of the supporting beams

e) patterning of a device layer (82), defining the geometrical dimensions of the sensing element (88) and of the supporting beams (85). A top view and a cross section XX is shown. The sensing element is entirely located within the boundaries of the sacrificial layer, as patterned during step b. The supporting beams are partially located on this sacrificial layer, as one end contacts the substrate

f) depositing and patterning of an infrared absorber layer (84) on the polycrystalline SiGe layer.

g) removing the sacrificial layer (81). This step is also called the release of the bolometer. The sensing element is now only connected to the surrounding circuitry trough its supporting beams, as illustrated in figure 3 for the case of rectangular beams.

The steps of only partial patterning the sacrificial layer (b) and then the creation of the islands of sacrificial layer (c) can be switched if needed. In this case, first the islands are defined and afterwards the cavities are defined.

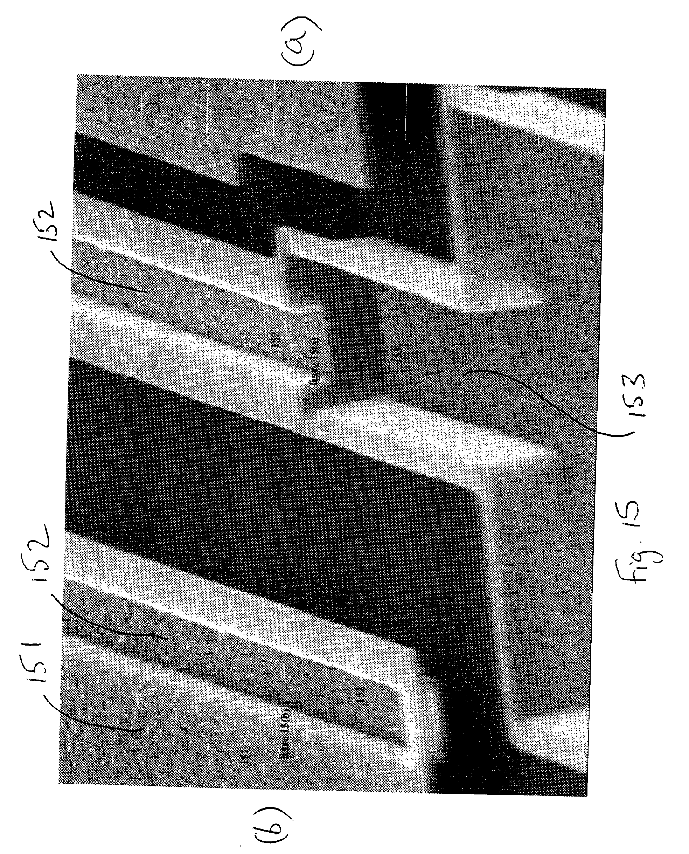

By patterning a cavity in the sacrificial layer, the desired topography is created for the subsequent processing of the SiGe semiconductor layer. This topography results in a U-shaped cross section of the resulting supporting beam, as the SiGe layer will follow the topography. Figure 15 shows the U-shaped supporting beam according to this embodiment.

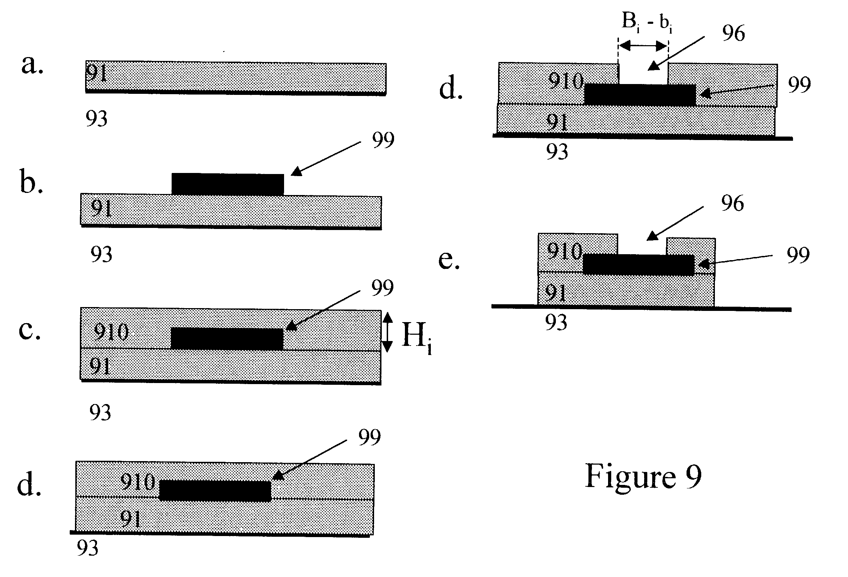

The processing of a bolometer having I-shaped supporting beams in accordance with an embodiment of the present invention may comprise the following steps, as illustrated in figure 9:

a) forming the first part (91) of the sacrificial layer on a substrate (93)

b) depositing and patterning of the bottom layer (99) of the I-profiled beam the bottom layer can be the same material as used for the top part of the I-profiled beam and the sensing element, but is not restricted to this

c) depositing the second part (910) of the sacrificial layer having thickness H; on top of this patterned bottom layer

d) patterning of the sacrificial layer thereby exposing the substrate

e) patterning only a part of this sacrificial layer. The obtained opening, cavity or trench (96) has a width ($B_l$ - $b_i$) as defined in figure 6b. The sacrificial layer is locally etched until the bottom layer of the I-profiled beam is reached.

The subsequent processing comprises the steps of depositing and patterning the SiGe semiconductor and infrared absorber layer, of removing the sacrificial layer are similar to the one described in European Patent no 0 867 702 and are illustrated in figure 7 in the case of U-shaped supporting beams.

The profiling of the supporting beams is done in the course of processing the bolometer. Although a limited number of additional process steps are required, these process steps can be integrated in the standard process sequence of the MEMS device. The depth d of the U-profile is determined by the partial patterning of the sacrificial layer in step b, and can be easily adapted by changing for example the etch time or the thickness of the sacrificial layer. In figure 6 the moment of inertia $I_U$ of the U-profile is compared to the moment of inertia $I_R$ of a rectangular profile having beam height H, here equal to the layer thickness t and width B. There is an improvement in stiffness $R_1$ given by the following expression:

$$\frac{I_U}{I_R} = \frac{B_u H_u^{\ 3} - b_u h_u^{\ 3}}{Bt^3} \tag{6}$$

Comparing the cross section $S_U$ of the U-profile to the cross section $S_R$ of a rectangular profile having thickness H and with B, there is a reduction in area $R_1$ :

$$\frac{S_U}{S_R} = \frac{B_u H_u - b_u h_u}{Bt} \tag{7}$$

Since an aim of the present invention is to combine a maximal thermal insulation, hence a minimal section, with a maximal stiffness, the ratio of the moment of inertia I to the cross section S should be maximized. When comparing classical rectangular profiles with U-profiles, a figure of merit M can be defined. In case of the rectangular and U-profile defined in figure 6, this figure of merit M can be expressed as:

$$M = \frac{(\frac{I}{S})_U}{(\frac{I}{S})_R} = \frac{(B_u H_u{}^3 - b_u h_u{}^3)}{(B_u H_u - b_u h_u)} \frac{1}{t^2} \tag{8}$$

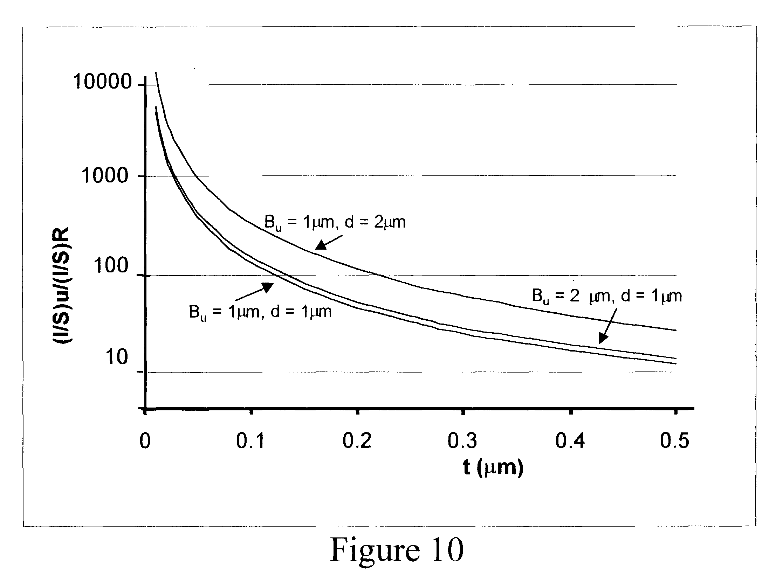

This figure of merit M is plotted in figure 10, comparing a rectangular profile with a U-shaped profile. The value of width $B_u$ and depth d is kept constant, while the thickness t of the layer is varied, and hence the value of dimensions $H_u$, $h_u$ and $b_u$. All the dimensions of both profiles can be adapted by changes in processing parameters.

For all curves, the figure of merit increases with decreasing layer thickness t. Decreasing the layer thickness is very useful, as maximal thermal insulation is obtained by minimal layer thickness. For rather thick device layers of 0.5 micron, the figure of merit is already in the order of 11, while for 10 times thinner layers, the figure of merit is above 1000. This value reflects a deflection 1000 times less at a given force for a beam having the same thermal insulation. There is only a small dependence of M on the width $B_u$, but on the other hand the influence of an increased U-profile depth d, resulting in a higher outer height $H_u$ of the U-profile, is clear. This is due to the fact that the moment of inertia is proportional to $H_u{}^3$, while the section is only proportional to $H_u$. Both I and S scale with $B_u$, resulting in a minor change in relative figure of merit as a function of $B_u$. The figure of merit M expresses the fact that a non-rectangular cross section of the supporting beam can improve the mechanical strength of such beam, while the mass and/or the cross sectional area of such beam is decreased in comparison with a rectangular beam. If a rectangular beam having the same mechanical strength is created, this beam will be heavier and/or have a larger cross sectional area.

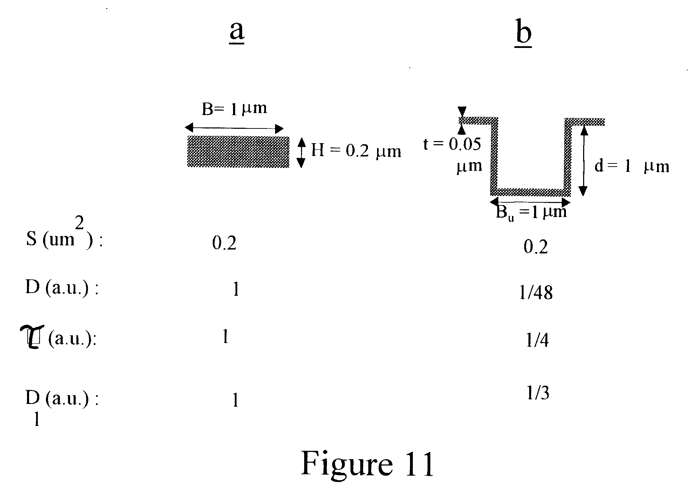

The gain in mechanical stiffness of an U-profile section compared to a rectangular beam, keeping the same thermal insulation, becomes even clearer if we take the example of a 50x50 $\mu m^2$ bolometer, supported by 2 beams with length L = 45μm. Such a bolometer equipped with classical rectangular beams of width B = 1 μm and device layer thickness t = 0.2 μm, has a fairly low beam section of $S_R = 0.2\ \mu m^2$, resulting in a high thermal insulation. If we construct a 0.05 micrometer thin U-profile of width $B_u$ = 1 micrometer, and having a U-profile depth of d = 1 micrometer, exactly the same section of 0.2 $\mu m^2$ is realized. However, due to the increased moment of inertia of the beams, the deflection D at a given force F is reduced almost by 2 orders of magnitude as shown in figure 11. Also the resistance to lateral forces K, i.e. to forces applied to the side of the beams as shown in figure 5, is improved by using U-profiles instead of rectangular beams. As shown in figure the lateral deflection $D_1$ decreases with a factor of 3.

U-profiles can be very useful in all thermally insulated MEMS or micromachined systems. More in general will the use of U-profile provide more mechanical robustness to MEMS systems even when using thin layers.

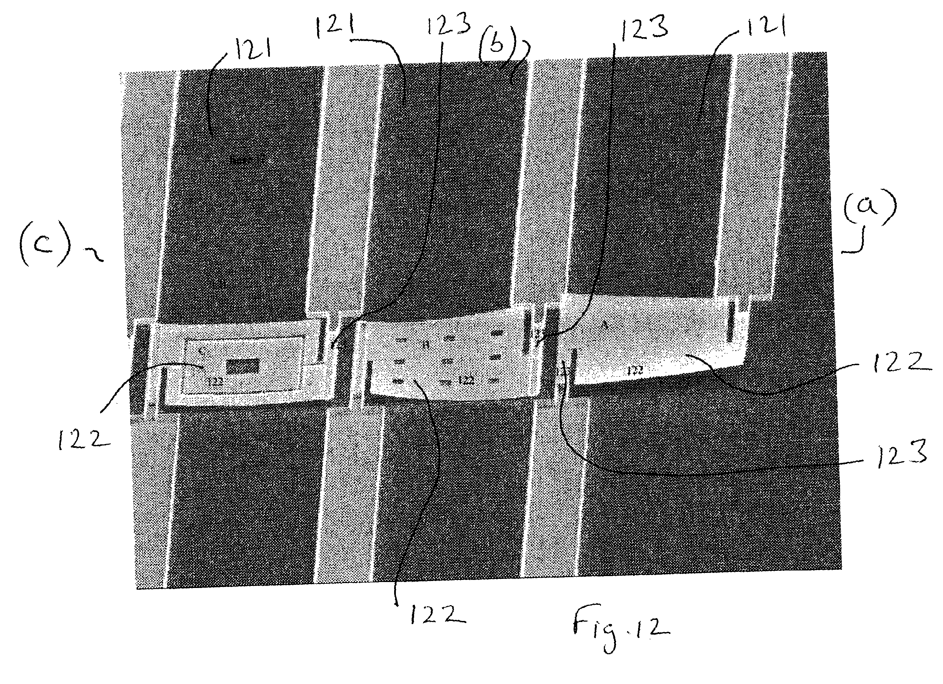

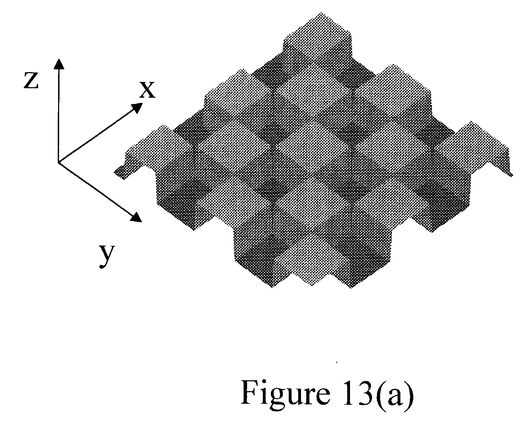

However, the U-profile approach is not limited to beams or to thermal sensors. Any MEMS structure, membrane or planar element can be made mechanically more stiff using a combination of perpendicular U-profiles. One can compare this with a sheet of corrugated iron or board: the U-profile is repeated along the length of the sheet. In figure 12 several embodiments of the invention are illustrated by means of SEM pictures. First no profiling in the beams or the planar element is done, using the standard MEMS processing. Both, beams and planar element, have a rectangular cross section. Then (figure 12b) during the processing the supporting beams are shaped in a U-profile, thereby decreasing the deformation of the MEMS devices. In figure 12c also the planar element is at least partly shaped with a U-profile, together with the supporting beams, thereby further decreasing the deformation of the MEMS devices. In figure 13(a) the U-profile is repeated over the area of the sensing element. If the U-profile is repeated for example in 2 directions, one obtains a structure alike an egg box. Although finite-element simulations are required to quantify the gain in mechanical stiffness, classic mechanics theory and hardware simulation shows evidence for a large stiffness enhancement. Applying such corrugated board structure enables the use of thin, yet mechanically robust structures. In figure 13(b) this embodiment is illustrated having the planar element is shaped in a three-dimensional way. In figure 14 the improved mechanical strength towards external forces is illustrated as a large piece of silicon is put on top of the profiled planar element, whereby no deformation of the MEMS devices is noticed.

The improvement of the mechanical strength of the supporting beams, but also of the MEMS-structure or planar element itself, can solve the problem of residual strain gradients in the material. In MEMS processing one has to take this internal stress into account, as this stress might be of greater concern than the stress resulting from external forces. For example if two materials, having different thermal expansion coefficients, are attached to each other to form a bi-layer, this bi-layer will deform, e.g. bent up-or downwards, when thermal processing is applied. This deformation can be limited when the layout of cross section of the bi-layer is changed, as explained above. As profiling, i.e. creating topography, of the supporting beams and/or the sensor or planar element improves the mechanical strength of the devices, e.g. towards internal and external forces, an additional degree of freedom in the process development of such devices is introduced. The development of such devices has to be optimized towards their electro-mechanical properties. These properties can be dependent on the internal stress of the layers deposited or resulting from the subsequent processing steps. If this stress can be relieved by profiling the beam(s) and/or the planar element(s), the process engineer can do a further optimization of the characteristics of the MEMS devices.

MEMS devices, in which non-rectangular profiles such as U-profiles are applied, have the following advantages over MEMS devices with classical thick rectangular structures:

1) a shorter fabrication time, and hence lower fabrication cost, as for example deposition times can be considerably decreased when using thinner layers.

2) Due to the enhanced stiffness, such structures are less sensitive to mechanical stress resulting from internal or external forces.

3) Due to the enhanced stiffness, such structures can better withstand chemical or mechanical forces applied during fabrication and operation of the device.

4) Yet another advantage of this approach is clear. The time response, i.e. the time constant $\tau$ of a thermal sensor such as a bolometer, is given by the ratio of the thermal capacity C and the thermal conductance G:

$$\tau = \frac{C}{G} \tag{9}$$

Since the cross section S in the previous example is constant to 0.2 square microns ( $m^2$), the time constant $\tau$ scales directly with the thermal capacity C. The thermal capacitance C is direct proportional to the type and amount of material present. The amount of material present is proportional to the device layer thickness t. Since the layer thickness t in above example is reduced from 0.2 micron to 0.05 micron, i.e. by a factor 4. For a polySiGe bolometer with a planar element of 50 m x 50 m having a beam length of 45 m, the thermal time constant changes from 33 milliseconds to 8 milliseconds. This reduction in thermal time constant enables the use of bolometers arrays for fast imaging camera applications, where time constants equal or below 10 milliseconds are required. In the classical bolometer fabrication process, this time requirement puts a limit on the maximal sensitivity that can be attained. So, the use of U-profiles in bolometer fabrication not only enhances the mechanical stiffness of the devices, but also considerable reduces the thermal time constant, even without changing the thermal insulation. 5) In standard MEMS technology using rectangular supporting beams, the cross section of the beams can be minimized by decreasing their width B. The minimal width B is limited by the state-of-the art lithography and etching techniques. In the state-of-the-art technology this minimal width B is slightly below 1 micron. In case of a U-shaped profile the minimal linewidth feature is the opening $B_u$ of the U-profile, as defined in figure 6. As explained above the thermal conductivity of the beams is determined by the overall cross section. Therefore a U-profile using a thin device layer thickness t allows larger beam width W and width of the opening of the sacrificial layer $B_u$. As a consequence no advanced and expensive lithographic patterning including high cost reticule sets, are required as these linewidths can be larger than 1 micrometer. In figure 15 the U-shaped beam has as dimension W = 3.2 m and $B_u$ = 1.6 m. U-shaped beams having dimensions W = 1.2 m and $B_u$ = 0.6 m have been realized.

**Claims**

1. A Micro Electro Mechanical System device, comprising

   a semiconductor substrate;
   a support system, comprising at least one element
   said support system being connected to said substrate;
   at least one element of said support system having a figure of merit M at least larger than 1;
   said figure of merit M being defined as the ratio of a first parameter to a second parameter;
   said first parameter being the ratio of moment of inertia along one axis to its corresponding cross sectional area of said element, and
   said second parameter being the ratio of moment of inertia along the same axis to its corresponding cross sectional area of an element with rectangular cross section

2. A device as recited in claim 1 wherein the mechanical strength of at least one element of said support system along one axis is substantially larger than the mechanical strength along the same axis of a reference element with a rectangular cross section and said rectangular cross section having the same cross sectional area along said axis as said element.

3. A device as recited in claim 1 or 2 wherein said element is an elongated beam.

4. A device as recited in claim 3 wherein said elongated beam has an I-shaped cross section perpendicular to the longitudinal direction of said elongated beam.

5. A device as recited in claim 3 wherein said elongated beam has a U-shaped cross section perpendicular to the longitudinal direction of said elongated beam.

6. A device as recited in claim 1 or 2 wherein said element is a planar element.

7. A device as recited in claim 6 wherein at least a part of said planar element has a U-shaped cross section.

8. A device as recited in claim 6 wherein at least a part of said planar element has an I-shaped cross section.

9. A device as recited in claim 1 wherein said device comprises at least one support system and wherein said support systems are arranged at different distances above said substrate.

10. A device as recited in claim 1 or 9, wherein said planar element is adapted for sensing electromagnetic radiation.

11. A device as recited in claim 1, 9 or 10, wherein said planar element is adapted for sensing infrared radiation.

12. A device as recited in claim 1 or 2 wherein said support system comprises a planar element and at least one beam element, said planar element and said beam element being patterned in the same polycrystalline SiGe layer and said planar element comprises an infra red absorber layer.

13. A camera comprising an array of devices, each device being as recited in any of the preceding claims.

14. A method of fabricating a Micro Electro Mechanical System device with improved mechanical strength, comprising the steps of

    1. forming a sacrificial layer on a semiconductor substrate;
    2. depositing a layer on said sacrificial layer;
    3. patterning said layer in order to form a support system, said support system comprising a planar element and at least one beam element;

    **characterized in that** after the step (1) of forming said sacrificial layer:
      4. at least one cavity is formed in said sacrificial layer

15. A method of fabricating a Micro Electro Mechanical System device with improved mechanical strength, comprising the steps of

    1. forming a sacrificial layer on a substrate;
    2. patterning said sacrificial layer, thereby exposing said substrate;
    3. depositing a layer on said sacrificial layer;
    4. patterning said layer in order to form a system, said system comprising a planar element and at least one beam element; said system being connected to said substrate,

    **characterized in that**

    at least one cavity is created in said sacrificial layer;
    during the step (2) of patterning of said sacrificial layer said cavity is preserved; and, after the step (4) of forming a support system, said support system is released by removing said sacrificial layer.

16. A method of fabricating a Micro Electro Mechanical System device with improved mechanical strength, as recited in claim 15:

    wherein said cavity (86) is preserved by depositing a protective layer (87) on said cavity (86), said protective layer extending substantially over said cavity (86);
    wherein said protective layer (87) is removed after patterning said sacrificial layer; and, wherein said layer (82) is patterned (step 4) such that said beam element (85)
    extends substantially over said cavity (86).

17. A method as recited in any of claims 14 to 16 where said layer comprises polycrystalline SiGe.

**18.** A method of fabricating a Micro Electro Mechanical System device with improved mechanical strength, comprising the steps of:

forming a first part of a sacrificial layer (91) on a semiconductor substrate (93); depositing on said first part a bottom layer (99)
patterning said bottom layer (99);
depositing a second part of said sacrificial layer (910);
patterning at least one cavity (96) in said second part of said sacrificial layer (910);

said cavity being located above said patterned bottom layer (99), said cavity being etched until said bottom layer (99) is substantially exposed;
depositing a protective layer (87) on said cavity (86), said protective layer extending substantially over said cavity (86);
patterning said sacrificial layer until said semiconductor substrate is exposed;
removing said protective layer (87);
depositing a layer (82) on said patterned sacrificial layer;
patterning said layer in order to form a support system, said support system comprising a planar element and at least one beam element; said beam element (85) or said planar element (88) are extending substantially over said cavity (86); and, removing said sacrificial layer.

**19.** A method as recited in claim 18 where said layer and bottom layer comprise polycrystalline SiGe.

Figure 1

Figure 2

Figure 3

Figure 4

Figure 5

| | I | S |
|---|---|---|
| a | $\dfrac{B\,H^3}{12}$ | $B\,H$ |
| b | $\dfrac{B_i\,H_i^3 - b_i\,h_i^3}{12}$ | $B_i H_i - b_i h_i$ |
| c | $\dfrac{B_u\,H_u^3 - b_u\,h_u^3}{12}$ | $B_u H_u - b_u h_u$ |

$W = 2(B_u - t)$

$H_u = d + t,\ h_u = d - t,\ b_u = B_u - 2t$

Figure 6

Figure 7

EP 1 136 440 A1

Figure 7

Figure 8

EP 1 136 440 A1

f.

83

82

85

85

84

X

X

84

82

82
85

g.

81

X-X

83

Figure 8

Figure 9

Figure 10

<u>a</u>                                    <u>b</u>

B= 1 μm

H = 0.2 μm

t = 0.05 μm

d = 1 μm

$B_u$ =1 μm

S (um$^2$) :            0.2                    0.2

D (a.u.) :              1                     1/48

$\mathcal{T}$ (a.u.):              1                     1/4

D (a.u.) :              1                     1/3
1

Figure 11

Fig. 12

EP 1 136 440 A1

Figure 13(a)

fig. 13(b)

Fig. 14

(a)

(b)

151

152

152

153

Fig. 15

**European Patent Office**

## EUROPEAN SEARCH REPORT

Application Number

EP 00 20 1083

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 753 671 A (CEA) 15 January 1997 (1997-01-15) * the whole document * | 1-13 | B81B3/00 G01J5/20 H01L31/09 |
| X | BRUGGER J ET AL: "Silicon Micro/Nanomechanical Device Fabrication Based on Focused Ion Beam Surface Modification and KOH Etching" MICROELECTRONIC ENGINEERING,NL,ELSEVIER PUBLISHERS BV., AMSTERDAM, vol. 35, no. 1, 1 February 1997 (1997-02-01), pages 401-404, XP004054087 ISSN: 0167-9317 * figure 1 * | 1-3,6 | |
| X | US 5 962 909 A (INSTITUT NATIONAL D'OPTIQUE) 5 October 1999 (1999-10-05) * figures * | 14,15 | |
| X | US 5 439 552 A (CSEM) 8 August 1995 (1995-08-08) * figures 5-14 * | 14-16 | TECHNICAL FIELDS SEARCHED (Int.Cl.7) B81B G01J H01L |
| A | US 5 645 684 A (UNIV. OF CALIFORNIA) 8 July 1997 (1997-07-08) * abstract * | 18 | |
| D,A | EP 0 867 702 A (IMEC) 30 September 1998 (1998-09-30) * abstract * | 1 | |

The present search report has been drawn up for all claims

| Place of search | Date of completion of the search | Examiner |
|---|---|---|
| THE HAGUE | 6 September 2000 | GORI, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EP 1 136 440 A1

European Patent Office

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-17

**European Patent Office**

## LACK OF UNITY OF INVENTION
### SHEET B

Application Number

EP 00 20 1083

The Search Division considers that the present European patent application does not comply with the requirements of unity of invention and relates to several inventions or groups of inventions, namely:

1. Claims: 1-17

    Microelectromechanical system (claims 1-13) and a first process of fabrication

2. Claims: 18-19

    A second process of fabrication for the micro electromechanical system of claims 1-13 (completely antipated).

**ANNEX TO THE EUROPEAN SEARCH REPORT
ON EUROPEAN PATENT APPLICATION NO.**     EP 00 20 1083

This annex lists the patent family members relating to the patent documents cited in the above-mentioned European search report.
The members are as contained in the European Patent Office EDP file on
The European Patent Office is in no way liable for these particulars which are merely given for the purpose of information.

06-09-2000

| Patent document cited in search report | | Publication date | Patent family member(s) | | Publication date |
|---|---|---|---|---|---|
| EP 753671 | A | 15-01-1997 | FR | 2736654 A | 17-01-1997 |
| | | | JP | 9043061 A | 14-02-1997 |
| | | | US | 5949119 A | 07-09-1999 |
| | | | US | 5930594 A | 27-07-1999 |
| US 5962909 | A | 05-10-1999 | AU | 3936097 A | 02-04-1998 |
| | | | WO | 9811611 A | 19-03-1998 |
| | | | US | 6130109 A | 10-10-2000 |
| US 5439552 | A | 08-08-1995 | FR | 2697536 A | 06-05-1994 |
| | | | DE | 69301450 D | 14-03-1996 |
| | | | DE | 69301450 T | 12-09-1996 |
| | | | EP | 0596455 A | 11-05-1994 |
| | | | JP | 6216083 A | 05-08-1994 |
| US 5645684 | A | 08-07-1997 | US | 5660680 A | 26-08-1997 |
| | | | AU | 5796096 A | 30-12-1996 |
| | | | EP | 0838084 A | 29-04-1998 |
| | | | WO | 9641368 A | 19-12-1996 |
| | | | AU | 1979995 A | 25-09-1995 |
| | | | AU | 1985595 A | 25-09-1995 |
| | | | EP | 0749474 A | 27-12-1996 |
| | | | EP | 0764346 A | 26-03-1997 |
| | | | JP | 9512250 T | 09-12-1997 |
| | | | JP | 9512955 T | 22-12-1997 |
| | | | US | 5985328 A | 16-11-1999 |
| | | | WO | 9524472 A | 14-09-1995 |
| | | | WO | 9524736 A | 14-09-1995 |
| | | | US | 6044981 A | 04-04-2000 |
| | | | US | 5893974 A | 13-04-1999 |
| | | | US | 6015599 A | 18-01-2000 |
| | | | US | 5770076 A | 23-06-1998 |
| | | | US | 5798042 A | 25-08-1998 |
| | | | US | 5985164 A | 16-11-1999 |
| EP 867702 | A | 30-09-1998 | EP | 0867701 A | 30-09-1998 |
| | | | JP | 11040824 A | 12-02-1999 |

EPO FORM P0459

For more details about this annex : see Official Journal of the European Patent Office, No. 12/82